# EUROPEAN PATENT APPLICATION

(11) **EP 4 779 865 A1**
(43) Date of publication of application: **22.07.2026**
(21) Application number: 26150070.6
(22) Date of filing: 02.01.2026
(51) Int. Cl.: H03F 3/08, H03F 3/45, H03F 1/02

(54) **STACKED FEEDBACK TRANSIMPEDANCE AMPLIFIERS**

(30) Priority: 15.01.2025 US 202519021685
(71) Applicant: InfiniLink Inc., Wilmington, DE 19801 (US)
(72) Inventor: Awad, Ramy, Wilmington, DE, 19801 (US); Mohamed, Amal Gaafar Ahmed, Wilmington, DE, 19801 (US)
(74) Representative: Grünecker Patent- und Rechtsanwälte PartG mbB

(57) **Abstract**

The techniques described herein relate to stacked feedback transimpedance amplifiers. An example transimpedance amplifier includes a first amplifier comprising a first terminal, and a second amplifier comprising a second terminal, the second terminal coupled to the first terminal, wherein the first amplifier and the second amplifier are configured to reverse bias a photodetector.

## Description

### FIELD

The techniques described herein relate generally to circuits and, more particularly, to stacked feedback transimpedance amplifiers.

### BACKGROUND

Data center networking demands are substantially increasing, driven by technologies such as fifth generation cellular (i.e., 5G), artificial intelligence and machine learning (AI/ML), cloud storage, Internet-of-Things (IoT), and video conferencing. Such technologies use high-bandwidth data links, which may include 100 gigabit/second (Gb/s) or greater capabilities over distances ranging from meters to kilometers.

Optical links may be used to implement these high-bandwidth data links by using an optical transmitter to transmit light through an optical medium, such as optical fibers, to an optical receiver. An optical receiver may include a photodetector and associated circuitry to detect and convert received light into an electrical signal for subsequent data communication processing.

### SUMMARY

In accordance with the disclosed subject matter, stacked feedback transimpedance amplifiers are disclosed.

Some embodiments relate to an example transimpedance amplifier that includes a first amplifier comprising a first terminal, and a second amplifier comprising a second terminal, the second terminal coupled to the first terminal, wherein the first amplifier and the second amplifier are configured to reverse bias a photodetector.

Some embodiments relate to a circuit comprising a transimpedance amplifier comprising: a first amplifier comprising a first terminal, and a second amplifier comprising a second terminal, the second terminal coupled to the first terminal, wherein the first amplifier and the second amplifier are configured to reverse bias a photodetector. The circuit further comprises a filter circuit coupled to the transimpedance amplifier and configured to reduce the bias from an output of the transimpedance amplifier.

Some embodiments relate to an optical receiver. The optical receiver comprises a transimpedance amplifier circuit configured to receive a current converted from an optical signal by a photodetector, the transimpedance amplifier circuit comprising a first amplifier and a second amplifier in a stacked arrangement configured to reverse bias the photodetector. The optical receiver further comprises a first direct current control loop configured to control current through a first feedback network of the first amplifier, and a second direct current control loop configured to control current through a second feedback network of the first amplifier.

The foregoing summary is not intended to be limiting. Moreover, various aspects of the present disclosure may be implemented alone or in combination with other aspects.

### BRIEF DESCRIPTION OF FIGURES

Various aspects and embodiments will be described with reference to the following figures. In the figures, each identical or nearly identical component that is illustrated in various figures is represented by a like reference character. For purposes of clarity, not every component may be labeled in every drawing. The drawings are not necessarily drawn to scale, with emphasis instead being placed on illustrating various aspects of the techniques and devices described herein.
FIG. 1 shows an example communication system including an optical receiver in an optical cable effectuating communication between networked computing devices, in accordance with some embodiments of the technology described herein.
FIG. 2 shows an example implementation of the optical receiver of FIG. 1, in accordance with some embodiments of the technology described herein.
FIG. 3 shows another example implementation of the optical receiver of FIG. 1, which includes an example programmable diode stack, example gain control circuits, and example bandwidth stabilization circuits, in accordance with some embodiments of the technology described herein.
FIG. 4 shows an example implementation of the programmable diode stack of FIG. 3, in accordance with some embodiments of the technology described herein.
FIG. 5 shows example respective implementations of the gain control circuits and the bandwidth stabilization circuits of FIG. 3, in accordance with some embodiments of the technology described herein.
FIG. 6A shows example operation a portion of the optical receiver of FIG. 3, in accordance with some embodiments of the technology described herein.
FIG. 6B shows waveforms representing example operation of the optical receiver portion shown in FIG. 6A, in accordance with some embodiments of the technology described herein.
FIG. 7A shows another portion of the optical receiver of FIG. 3, in accordance with some embodiments of the technology described herein.
FIG. 7B shows waveforms representing example operation of the optical receiver portion shown in FIG. 7A, in accordance with some embodiments of the technology described herein.
FIG. 8 shows an example implementation of a transimpedance amplifier.
FIG. 9 shows another example implementation of a transimpedance amplifier.

### DETAILED DESCRIPTION

The present application generally provides for optical receivers that implement high-bandwidth communication links with improved signal integrity and noise performance compared to conventional optical receivers. Optical receivers as disclosed herein may include a transimpedance amplifier (TIA) configured to convert current output from a photodetector, which detects light from an optical medium, into a voltage. The TIA may be configured with a stacked differential shunt-feedback topology, which enhances signal-to-noise ratio (SNR) by at least 3 decibels (dB). Some such optical receivers may include a direct current (DC) current control loop associated with the TIA to adjust the TIA bias and operating point for optimized and/or otherwise improved performance. The DC current control loop may be configured to subtract and/or remove the relatively large DC current from the photodetector to avoid blocking the optical receiver with a large DC signal. Beneficially, the bandwidth of the DC current control loop may be configured with a relatively low cut-off frequency to avoid causing and/or introducing baseline wandering.

In some embodiments, the optical receivers may include a programmable diode stack to dynamically control a photodetector's reverse bias to optimize and/or otherwise improve bandwidth. The optical receivers may include a programmable gain amplifier with peaking control to enable up to at least 10 dB gain adjustment for handling varying communication signal ranges in high-speed optical communications.

Optical receivers are used to implement optical links for high-bandwidth technologies and applications thereof, such as fifth generation cellular (i.e., 5G), artificial intelligence and machine learning (AI/ML), cloud storage, Internet-of-Things (IoT), and video conferencing. Such optical links may include 100 gigabit/second (Gb/s) or greater capabilities over distances ranging from meters to kilometers.

An example application for such high-bandwidth technologies is data center networking, which may include thousands, tens of thousands, or even hundreds of thousands of links (e.g., communication links), such as optical links (e.g., optical communication links), to facilitate data communication between networked computing devices (e.g., computer servers). An optical link may be implemented at least in part by an optical cable. An optical cable can include various types of fibers to transmit light. For example, an optical cable that uses thin glass fibers is referred to as a fiber optic cable.

To meet the bandwidth and reach requirements of data center applications, optical links need substantial power and cost improvements for broad data center adoption. To address these needs, high-speed communication standards are being adopted such as 400G-DR4, 400G-FR4, 400G-LR4, and 800G-DR8 standardized by the Institute of Electrical and Electronics Engineers (IEEE). These standards increasingly rely on four-level Pulse-Amplitude Modulation (PAM4) to double data rates over Non-Return-to-Zero (NRZ) modulation while staying within the same bandwidth constraints. However, the inventors have recognized that this transition to PAM4 presents significant technological challenges related to linearity, power efficiency, and signal noise-particularly in the optical receiver front end, where circuitry such as transimpedance amplifiers (TIAs) convert photodetector currents to voltage signals.

A first conventional implementation of an optical receiver front end includes a photodetector and a single-ended shunt-feedback TIA (SE-SF-TIA). In a SE-SF-TIA implementation, only the anode side of the photodetector is used as the cathode side current is dumped to alternating current (AC) ground. The inventors have recognized that the SE-SF-TIA suffers from debilitating tradeoffs between its noise and bandwidth because, since it only measures the signal on one line (e.g., the anode side), it is susceptible to noise (e.g., external noise sources) and common-mode interference.

A second conventional implementation of an optical receiver front end includes a differential TIA that uses the photocurrent flowing out of both terminals of the photodetector. Since the photodetector current also flows in the complementary branch, the signal increases by 6dB at the cost of a 3dB increase in noise, resulting in a theoretical 3dB increase in SNR. However, in contrast to the SE-SF-TIA, the photodetector in a differential TIA implementation needs reverse bias to have high bandwidth, which leads to multiple technical challenges recognized by the inventors as discussed below.

Some differential TIA implementations use resistors to reverse bias the photodetector and capacitors (with a capacitance C) to block the DC components of the photocurrent. In such implementations, the capacitors are high-pass filters and the resistance of the resistors are relatively small (e.g., 100 ohms, 150 ohms, 200 ohms, etc.) to reverse bias the photodiode.

The inventors have recognized multiple technical challenges with such implementations. First, the inventors have recognized that since the resistance (R) is relatively small, the cutoff frequency (also referred to as the corner frequency and determined by 1/RC) becomes relatively large and therefore reduces the bandwidth of the TIA. For example, the inventors have recognized that since high-speed communication signals (e.g., PAM4 signals) have a wide frequency range (e.g., a frequency range from DC up to tens of gigahertz (GHz) such as 10, 20, 30 GHz), the use of capacitors as high-pass filters blocks at least part of the received signal, which is undesirable. Second, the inventors have recognized that baseline wandering increases by blocking DC components of the photocurrent, which is particularly problematic in wireline applications.

The inventors have developed a differential TIA with stacked feedback to overcome the aforementioned technical challenges with conventional TIA implementations and achieves numerous benefits when incorporated into an optical receiver front end. In some embodiments, the TIAs are configured with a stacked differential shunt-feedback topology, which utilizes both sides of a photodetector to improve signal strength and thereby enhance SNR by 3dB over conventional SE-SF-TIA implementations. Such improved signal strength and enhanced SNR is beneficial in wireline applications, such as receiving PAM4 signals that are transmitted over an optical medium.

In some embodiments, the differential TIA developed by the inventors overcomes the technical challenge of reduced bandwidth in conventional TIA implementations. For example, some differential TIAs disclosed herein include a programmable diode stack that adjusts the photodetector's reverse bias dynamically to optimize and/or otherwise improve bandwidth.

In some embodiments, the differential TIA developed by the inventors overcomes the technical challenge of introducing baseline wandering as seen in conventional TIA implementations. For example, some differential TIAs disclosed herein include a DC current control loop with a bandwidth set to a relatively low cut-off frequency to avoid introducing baseline wander.

In some embodiments, the differential TIA developed by the inventors includes a programmable gain amplifier with peaking control, which offers up to 10dB gain adjustment for handling varying signal ranges in high-speed optical communications. Beneficially, the differential TIAs disclosed herein can be used in optical receiver front ends, which can be used to improve signal integrity and noise performance in high-speed optical communication systems.

The techniques described herein may be implemented in any of numerous ways, as the techniques are not limited to any particular manner of implementation. Examples of details of implementation are provided herein solely for illustrative purposes. Furthermore, the techniques disclosed herein may be used individually or in any suitable combination, as aspects of the technology described herein are not limited to the use of any particular technique or combination of techniques.

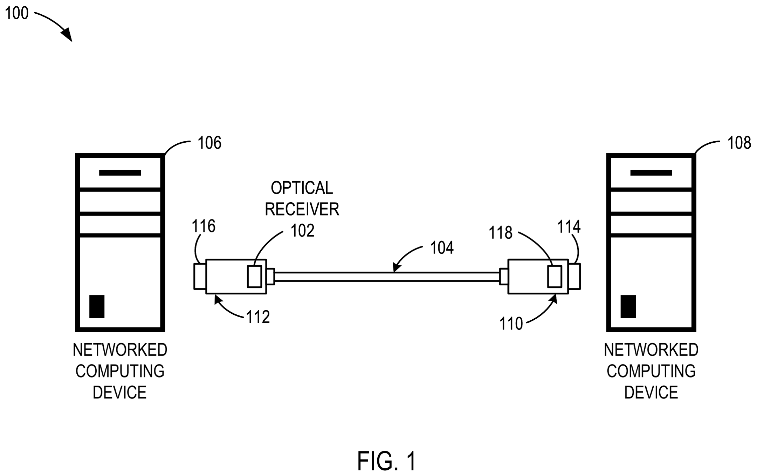

Turning to the figures, the illustrated example of FIG. 1 shows an example communication system 100 including an optical receiver 102 in an optical cable 104. The optical cable 104 can be used to effectuate communication between shown networked computing devices 106, 108, which include a first networked computing device 106 and a second networked computing device 108. For example, the optical cable 104 can be used to exchange data between the networked computing devices 106, 108 using optical signals.

As shown, the networked computing devices 106, 108 are servers (e.g., computer servers). Examples of servers include blade servers and rack-mounted servers. Additionally and/or alternatively, one(s) of the networked computing devices 106, 108 may be a desktop computer, a laptop computer, a tablet computer, a workstation, or any other type of computing and/or electronic device. Although only two networked computing devices 106, 108 are shown, more than two networked computing devices 106, 108 may be used to implement the communication system 100 of FIG. 1.

In some embodiments, the networked computing devices 106, 108 include at least one network interface configured to effectuate communication with at least one network. Examples of the at least one network interface include network interface circuitry, network interface cards (NICs), and smart NICs.

In some embodiments, the optical cable 104, the networked computing devices 106, 108, and/or, more generally, the communication system 100, may implement at least part of at least one network. The at least one network may be implemented by any wired and/or wireless network(s) such as one or more cellular networks (e.g., 4G LTE cellular networks, 5G cellular networks, future generation 6G cellular networks, etc.), one or more data buses, one or more local area networks (LANs), one or more data center networks, one or more optical fiber networks, one or more private networks, one or more public networks, one or more satellite networks, one or more wireless local area networks (WLANs), etc., and/or any combination(s) thereof. For example, the optical cable 104, the networked computing devices 106, 108, and/or, more generally, the communication system 100, may be part of a data center network. In such an example, the optical cable 104, the networked computing devices 106, 108, and/or, more generally, the communication system 100, may be in a data center.

In some embodiments, the at least one network interface can be configured to transmit and/or receive signals in accordance with a signal modulation technique. Examples of signal modulation techniques include Non-Return-to-Zero (NRZ) modulation (also referred to as two-level Pulse Amplitude Modulation), four-level Pulse-Amplitude Modulation (PAM4), eight-level Pulse-Amplitude Modulation (PAM8), and sixteen-level Pulse-Amplitude Modulation (PAM16). For example, at least one network interface of the first networked computing device 106 can transmit PAM4 signals to at least one network interface of the second networked computing device 108 via the optical cable 104.

The optical cable 104 can include various types of fibers to transmit light. For example, the optical cable 104 can be a fiber optic cable, which uses thin glass fibers to transmit light. Examples of fiber optic cables include single-mode fiber (SMF), multimode fiber (MMF), armored fiber, OM1, OM4, ribbon, simplex fiber, and avionics cables.

The optical cable 104 shown includes a first connector 110 on a first side of the optical cable 104 and a second connector 112 on a second side of the optical cable 104, and the second side is opposite the first side. The connectors 110, 112 of this example are plugs (e.g., plug connectors) because they are configured to be plugged into a receptacle at the networked computing devices 106, 108. Alternatively, one or both connectors 110, 112 may be receptacles.

The connectors 110, 112 respectively include an electrical connector 114, 116. The electrical connectors 114, 116 may be high-density electrical connectors such that the electrical connectors 114, 116 include a plurality of contacts (e.g., pins, sockets) for connection to the networked computing devices 106, 108.

The optical cable 104 shown is an active optical pluggable that is configured to be plugged into a network device, such as at least one network interface of the networked computing devices 106, 108. For example, the optical cable 104 may be plugged into a first network interface (e.g., a network port) of the first networked computing device 106 and a second network interface (e.g., a network port) of the second networked computing device 108. In such an example, the second networked computing device 108 may output electrical signals to the first connector 110, the first connector 110 may convert the electrical signals into optical signals for transmission over the optical cable 104 to the second connector 112, and the second connector 112 can convert the optical signals back into electrical signals for output to the first networked computing device 106.

The optical cable 104 shown is an active optical cable (AOC). An AOC is a cable that uses circuitry to convert electrical signals to light and back again to achieve faster data transfer over longer distances. Examples of AOC circuitry includes receivers (e.g., optical receivers), transmitters (e.g., optical transmitters), and transceivers (e.g., optical transceivers).

In the shown example, the first connector 110 includes an optical transmitter 118. The optical transmitter 118 can be implemented using circuitry configured to convert electrical signals received by the first electrical connector 114 into optical signals for transmission over the optical cable 104. For example, the optical transmitter 118 can convert electrical signals from at least one network interface of the second networked device 108 into optical signals for transmission over the optical cable 104.

In some embodiments, the optical transmitter 118 can implement and/or perform one or more signal conditioning techniques. Examples of signal conditioning techniques include DC offset removal, equalization, filtering, modulation, pre-amplification, and pre-emphasis. For example, the optical transmitter 118 can convert electrical PAM4 signals received from the second networked computing device 108 into an optical signal (e.g., light pulses) using a modulator and then transmit the optical signal through the optical cable 104. In such an example, the varying amplitudes of the optical signal can represent the different voltage levels of the PAM4 signal.

In some embodiments, the optical transmitter 118 can be implemented using at least one integrated circuit. Examples of an integrated circuit include an application specific integrated circuit (ASIC), a central processing unit (CPU), a digital signal processor (DSP), a field programmable gate array (FPGA), and a microcontroller.

In the shown example, the second connector 112 includes the optical receiver 102. The optical receiver 102 can be implemented using circuitry configured to convert optical signals transmitted by the optical transmitter 118 into electrical signals for output to the first networked computing device 106 via the second electrical connector 116.

In some embodiments, the optical receiver 102 can implement and/or perform one or more signal conditioning techniques. For example, the optical receiver 102 can implement and/or perform at least one of amplification (e.g., transimpedance amplification), DC offset removal, demodulation, equalization, or filtering. For example, the optical receiver 102 can use a photodetector to convert an optical signal received from the optical transmitter 118 into an electrical PAM4 signal that can be decoded to retrieve the data.

In some embodiments, the optical receiver 102 can be implemented using at least one integrated circuit. For example, the optical receiver 102 can be implemented using at least one of an ASIC, a CPU, a DSP, an FPGA, or a microcontroller.

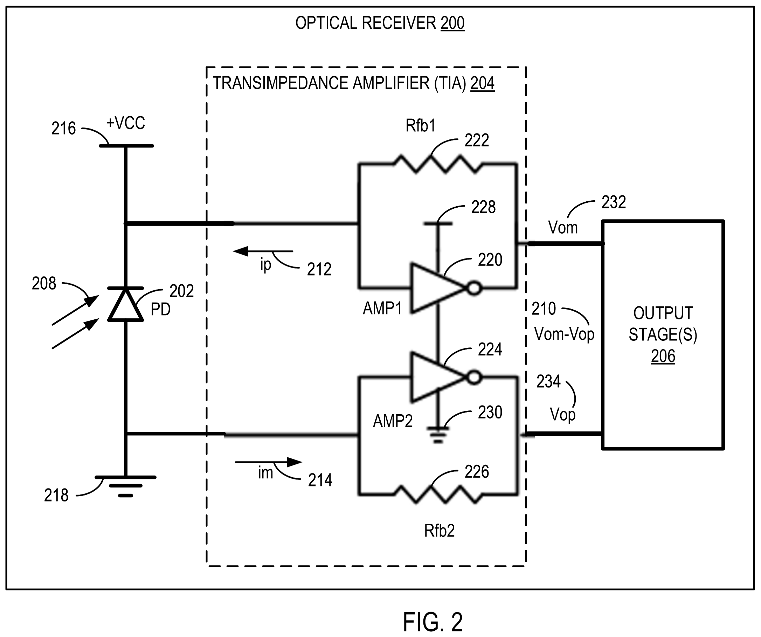

FIG. 2 shows an example optical receiver 200. In some embodiments, the optical receiver 200 of FIG. 2 can implement and/or correspond to the optical receiver 102 of FIG. 1. The optical receiver 200 shown is the front-end circuit of an optical receiver, which may also be referred to as an optical receiver front end.

The optical receiver 200 is a wireline receiver. Examples of a wireline receiver include an Ethernet interface and a High-Definition Multimedia Interface (HDMI).

The optical receiver 200 includes a photodetector 202, a transimpedance amplifier (TIA) 204, and output stage(s) 206 to convert an optical signal 208 into an electrical signal 210 (identified by Vom-Vop) for data recovery. For example, the optical signal 208 can be light transmitted through the optical cable 104 of FIG. 1 by the optical transmitter 118 and received by the optical receiver 102.

In some embodiments, the optical signal 208 is modulated in accordance with PAM4 such that amplitudes of the optical signal 208 represent the different voltage levels of PAM4. Alternatively, the optical signal 208 may be modulated in accordance with any other modulation technique such as NRZ modulation or higher level modulation such as PAM8 or PAM16.

The optical receiver 200 shown in FIG. 2 is an example implementation. For example, the photodetector 202, the TIA 204, and/or the output stage(s) 206 may be separate from the optical receiver 200. By way of example, the TIA 204 may be included in the optical receiver 200 and the photodetector 202 may be separate from the optical receiver 200 such that the optical receiver 200 is implemented by a first integrated circuit and the photodetector 202 is separate from and/or packaged differently than the first integrated circuit. In another example, the TIA 204 may be included on a first die of an integrated circuit and the photodetector 202 may be included on a second die of the integrated circuit. In yet another example, the TIA 204 may be included in an integrated circuit on a printed circuit board (PCB) and the photodetector 202 may be on the PCB but separate from the integrated circuit.

In the illustrated example of FIG. 2, the photodetector 202 is configured to convert the optical signal 208 into a first photocurrent 212 and a second photocurrent 214. The cathode of the photodetector 202 is coupled to a voltage source 216 (identified by +VCC) and the anode of the photodetector 202 is coupled to a reference node 218 (e.g., ground).

Components as described herein may be coupled to each via one or more electrical and/or optical connections. Examples of electrical connections include pads, traces, wires (e.g., interconnects), and vias. An example of an optical connection includes an opto-isolator. For example, the voltage source 216 and the photodetector 202 may be coupled together using at least one wire (e.g., at least one interconnect).

The photodetector 202 is a photodiode. Examples of photodiodes include P-N photodiodes, PIN photodiodes, and avalanche photodiodes. Alternatively, the photodetector 202 may be any other type of light detecting device that needs biasing (or reverse biasing), such as a phototransistor.

The TIA 204 of the illustrated example is implemented using a stacked differential shunt-feedback topology to convert the photocurrents 212, 214 into the electrical signal 210, which in this example is a differential voltage. The differential implementation uses both terminals of the photodetector 202, thereby doubling the signal current without compromising noise performance. For example, a first input of the TIA 204 is coupled to a first photodetector terminal (e.g., the cathode) of the photodetector 202 and a second input of the TIA 204 is coupled to a second photodetector terminal (e.g., the anode) of the photodetector 202. Beneficially, the TIA 204 shown in FIG. 2 achieves a 3dB improvement in SNR, which is desirable in high-sensitivity optical receivers.

The TIA 204 includes a first amplifier 220 (identified by AMP1) coupled to a first resistor 222 (identified by Rfb1) in a feedback arrangement. The first amplifier 220 is an inverting amplifier. Alternatively, the TIA 204 may be implemented by using a different type of amplifier for the first amplifier 220.

The first resistor 222 has a resistance Rfb1. An input of the first amplifier 220 and a first terminal of the first resistor 222 are coupled to the cathode of the photodetector 202.

The TIA 204 includes a second amplifier 224 (identified by AMP2) coupled to a second resistor 226 (identified by Rfb2) in a feedback arrangement. The second amplifier 224 is an inverting amplifier. Alternatively, the TIA 204 may be implemented by using a different type of amplifier for the second amplifier 224.

The second resistor 226 has a resistance Rfb2. In some embodiments, Rfb1 is the same as Rfb2 (e.g., the same resistance in a tolerance range, such as +/- 1%, 3%, 5%) while in other embodiments they are different. An input of the second amplifier 224 and a first terminal of the second resistor 226 are coupled to the anode of the photodetector 202.

The stacked differential shunt-feedback topology shown in FIG. 2 is implemented at least in part by coupling together the amplifiers 220, 224. For example, a first power supply terminal of the first amplifier 220 is coupled to a second power supply terminal of the second amplifier 224. As shown, the first power supply terminal of the first amplifier 220 is a negative power supply terminal and the second power supply terminal of the second amplifier 224 is a positive power supply terminal.

The TIA 204 is configured in a stacked differential arrangement to bias (e.g., reverse bias) the photodetector 202. For example, a differential voltage with respect to a voltage source 228 coupled to a positive power supply terminal of the first amplifier 220 and a reference node 230 coupled to a negative power supply terminal of the second amplifier 224 can be used to reverse bias the photodetector 202.

The TIA 204 is configured to convert the photocurrents 212, 214 into the electrical signal 210, which is a differential voltage. For example, the first amplifier 220 can be configured to convert and amplify the first photocurrent 212 into a first voltage 232 (identified by Vom). In such an example, the second amplifier 224 can be configured to convert and amplify the second photocurrent 214 into a second voltage 234 (identified by Vop).

The difference between the first voltage 232 and the second voltage 234 together form the differential voltage 210 identified in FIG. 2 as Vom-Vop (e.g., the difference between Vom and Vop). The differential voltage 210 is provided to the output stage(s) 206 for subsequent processing. For example, the output stage(s) 206 may include amplifiers (e.g., limiting amplifiers, variable gain amplifiers), filter(s), decision circuitry, and/or clock and data recovery (CDR) circuitry. In such an example, the output stage(s) 206 may include circuitry configured to output PAM4 electrical signals (or any other signals such as NRZ, PAM8, and PAM16 signals).

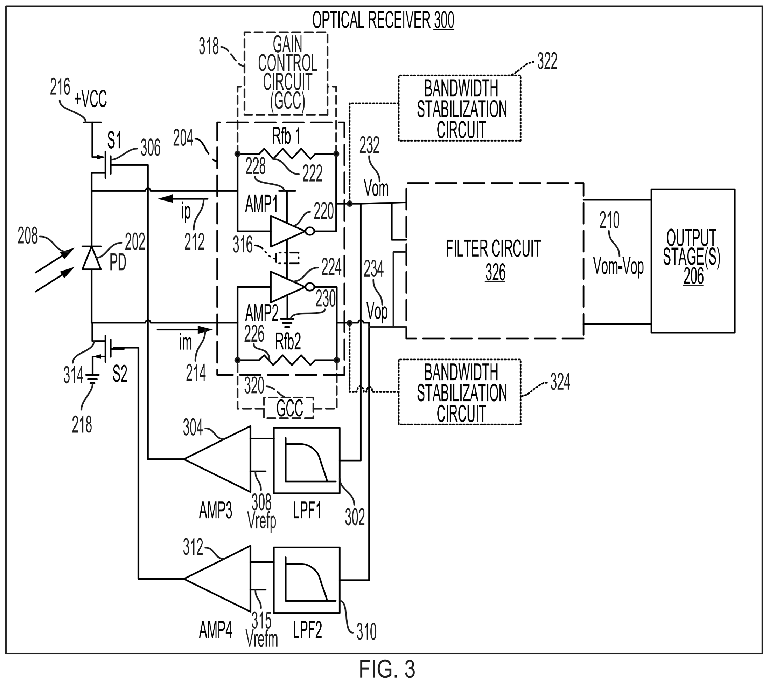

FIG. 3 shows another example optical receiver 300. In some embodiments, the optical receiver 300 of FIG. 3 can implement and/or correspond to the optical receiver 102 of FIG. 1 and/or the optical receiver 200 of FIG. 2. In some embodiments, the optical receiver 300 is an optical receiver front end. For example, the optical receiver 300 can be configured to convert the optical signal 208 into the electrical signal 210 of FIG. 2 for subsequent processing, such as data recovery.

The optical receiver 300 includes the TIA 204 of FIG. 2 to convert the photocurrents 212, 214 of FIG. 2 into the first voltage 232 and the second voltage 234 of FIG. 2. For example, the TIA 204 is implemented using a stacked differential arrangement to reverse bias the photodetector 202.

To overcome the technical challenge of introducing baseline wandering as seen in conventional TIA implementations, the TIA 204 uses stacked feedback resistors 222, 226 with respective DC current control (DCCC) loops. Beneficially, this configuration restricts DC current through the feedback resistors 222, 226 to ensure that substantially only the alternating current (AC) current contributes to the signal conversion. As discussed further below, this configuration can maintain the high-pass corner frequency below a threshold frequency (e.g., 50 kilohertz (kHz), effectively suppressing low-frequency drift in signal data (e.g., PAM4 signal data).

In the illustrated example of FIG. 3, there are two DCCC loops; a first DCCC loop associated the first amplifier 220 and a second DCCC loop associated with the second amplifier 224. The DCCC loops can be configured to adjust the TIA 204 bias and operating point for optimized and/or otherwise improved performance. For example, the DCCC loops can be configured such that if the output of the TIA 204 has DC current, then one(s) of the DCCC loops creates countercurrent to subtract the DC current from the photodetector 202 to avoid blocking the optical receiver 300 with a large DC signal. In such an example, the first DCCC loop can be configured to create countercurrent in response to any DC current flowing through the first resistor 222. The first DCCC loop includes at least the first amplifier 220, a first filter 302 (identified by LPF1), a third amplifier 304 (identified by AMP3), and a first switch 306 (identified by S1).

The first filter 302 is a low pass filter. Alternatively, the first filter 302 may be a different type of filter. The third amplifier 304 is a differential amplifier. Alternatively, the third amplifier 304 may be a different type of amplifier. The first switch 306 is a transistor. As shown, the first switch 306 is a p-channel metal-oxide-semiconductor field-effect transistor (MOSFET). Alternatively, the first switch 306 may be a different type of transistor.

In example operation, the photodetector 202 converts the optical signal 208 into at least the first photocurrent 212. The first amplifier 220 converts the first photocurrent 212 into an output voltage, which is shown as the first voltage 232. The first voltage 232 is equal to the negative product of the first photocurrent 212 and the resistance of the first resistor 222. The first photocurrent 212 flows through the first resistor 222 and the first amplifier 220 adjusts its voltage output to keep its inputs at equal voltages. The current to voltage gain of the first amplifier 220 is based on the feedback resistance (e.g., resistance Rfb1) of the first resistor 222.

In example operation, in response to a threshold minimum amount of DC current (e.g., 0.01 milliamperes (mA), 0.1 mA, etc.) flowing through the first resistor 222, the third amplifier 304 outputs current (e.g., countercurrent) that corresponds to the DC current. For example, the first voltage 232 is output to the first filter 302, which is configured to allow only relatively low frequencies to pass. In such an example, the first filter 302 can have a corner frequency of 50 kHz. Alternatively, the first filter 302 may have a different corner frequency, such as 10 kHz, 25 kHz, 75 kHz, or 100 kHz.

In example operation, the first filter 302 outputs the first voltage 232 with frequencies less than the corner frequency to the third amplifier 304. The third amplifier 304 outputs a voltage proportional to a difference between (i) the output voltage from the first filter 302 and (ii) a first reference voltage 308 (identified by Vrefp). In some embodiments, the first reference voltage 308 is constant while in other embodiments the first reference voltage 308 can be dynamically adjusted (e.g., by a controller).

As shown, the output voltage from the third amplifier 304 is output to a control terminal (e.g., a gate terminal) of the first switch 306. For example, the output voltage from the third amplifier 304 can be a control voltage (e.g., a gate voltage) to control the first switch 306.

By way of example, an increase in the output voltage can correspondingly decrease the DC current flowing from the voltage source 216 through the first switch 306. In such an example, larger DC currents flowing through the first resistor 222 can cause increased voltage output from the third amplifier 304, which reduces the DC current flowing through the first switch 306 and thereby reduces the DC current flowing through the first resistor 222. Thus, the first DCCC loop can dynamically adjust (e.g., reduce) the DC current flowing through the first resistor 222 to adjust the bias of the TIA 204 and subtract the DC current from the photodetector 202 to avoid blocking the optical receiver 300 with a large DC signal. Conversely, a decrease in the output voltage from the third amplifier 304 can correspondingly increase the current flowing through the first switch 306.

The second DCCC loop can be configured to create countercurrent in response to any DC current flowing through the second resistor 226. The second DCCC loop includes at least the second amplifier 224, a second filter 310 (identified by LPF2), a fourth amplifier 312 (identified by AMP4), and a second switch 314 (identified by S2).

The second filter 310 is a low pass filter. Alternatively, the second filter 310 may be a different type of filter. The fourth amplifier 312 is a differential amplifier. Alternatively, the fourth amplifier 312 may be a different type of amplifier. The second switch 314 is a transistor. As shown, the second switch 314 is an n-channel MOSFET. Alternatively, the second switch 314 may be a different type of transistor.

In example operation, the photodetector 202 converts the optical signal 208 into at least the second photocurrent 214. The second amplifier 224 converts the second photocurrent 214 into an output voltage, which is shown as the second voltage 234. The second voltage 234 is equal to the negative product of the second photocurrent 214 and the resistance of the second resistor 226. The second photocurrent 214 flows through the second resistor 226 and the second amplifier 224 adjusts its voltage output to keep its inputs at equal voltages. The current to voltage gain of the second amplifier 224 is based on the feedback resistance (e.g., resistance Rfb2) of the second resistor 226.

In example operation, in response to a threshold minimum amount of DC current (e.g., 0.01 mA, 0.1 mA, etc.) flowing through the second resistor 226, the fourth amplifier 312 outputs current (e.g., countercurrent) that corresponds to the DC current. For example, the second voltage 234 is output to the second filter 310, which is configured to allow only relatively low frequencies to pass. In such an example, the second filter 310 can have a corner frequency of 50 kHz. Alternatively, the second filter 310 may have a different corner frequency, such as 10 kHz, 25 kHz, 75 kHz, or 100 kHz.

In some embodiments, the first filter 302 and the second filter 310 are configured to have the same corner frequency (e.g., 50 kHz). Alternatively, the first filter 302 and the second filter 310 may be configured to have different corner frequencies.

In example operation, the second filter 310 outputs the second voltage 234 with frequencies less than the corner frequency to the fourth amplifier 312. The fourth amplifier 312 outputs a voltage proportional to a difference between (i) the output voltage from the second filter 310 and (ii) a second reference voltage 315 (identified by Vrefm). In some embodiments, the second reference voltage 315 is constant while in other embodiments the second reference voltage 315 can be dynamically adjusted (e.g., by a controller).

The output voltage from the fourth amplifier 312 is output to a control terminal (e.g., a gate terminal) of the second switch 314. For example, the output voltage from the third amplifier 304 can be a control voltage (e.g., a gate voltage) to control the first switch 306.

By way of example, an increase in the output voltage can correspondingly decrease the DC current flowing from the voltage source 216 through the second switch 314. In such an example, larger DC currents flowing through the second resistor 226 can cause increased voltage output from the fourth amplifier 312, which increases the DC current flowing through the second switch 314 and thereby reduces the DC current flowing through the second resistor 226. Thus, the second DCCC loop can dynamically adjust (e.g., reduce) the DC current flowing through the second resistor 226 to adjust the bias of the TIA 204 and subtract the DC current from the photodetector 202 to avoid blocking the optical receiver 300 with a large DC signal. Conversely, a decrease in the output voltage from the fourth amplifier 312 can correspondingly decrease the current flowing through the second switch 314.

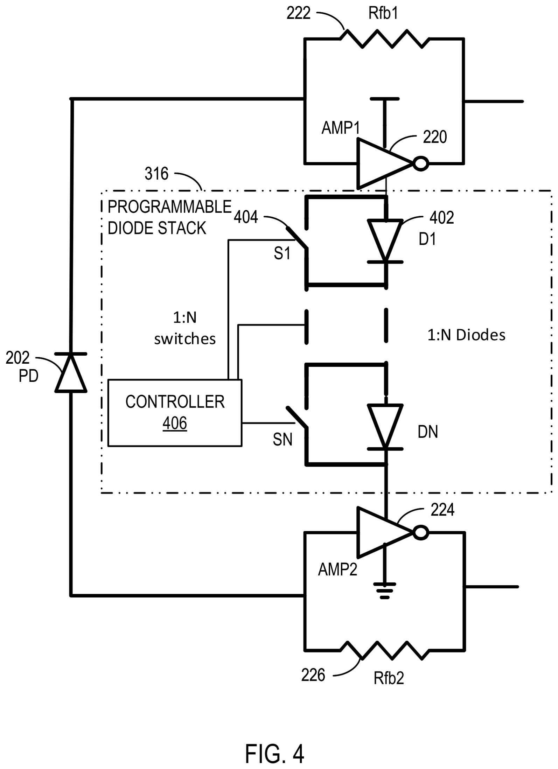

In the illustrated example, the optical receiver 300 further includes a programmable diode stack 316 coupled between the first amplifier 220 and the second amplifier 224. An example implementation of the programmable diode stack 316 is discussed below in connection with FIG. 4. Alternatively, the optical receiver 300 may not include the programmable diode stack 316.

In some embodiments, the programmable diode stack 316 can be configured to dynamically adjust a reverse bias of the photodetector 202. Beneficially, the programmable diode stack 316 can enhance photodetector bandwidth by allowing the reverse bias to be optimized for varying operating conditions of the optical receiver 300. Beneficially, the programmable diode stack 316 can be configured to maintain a relatively low AC resistance, further boosting signal integrity without compromising bandwidth.

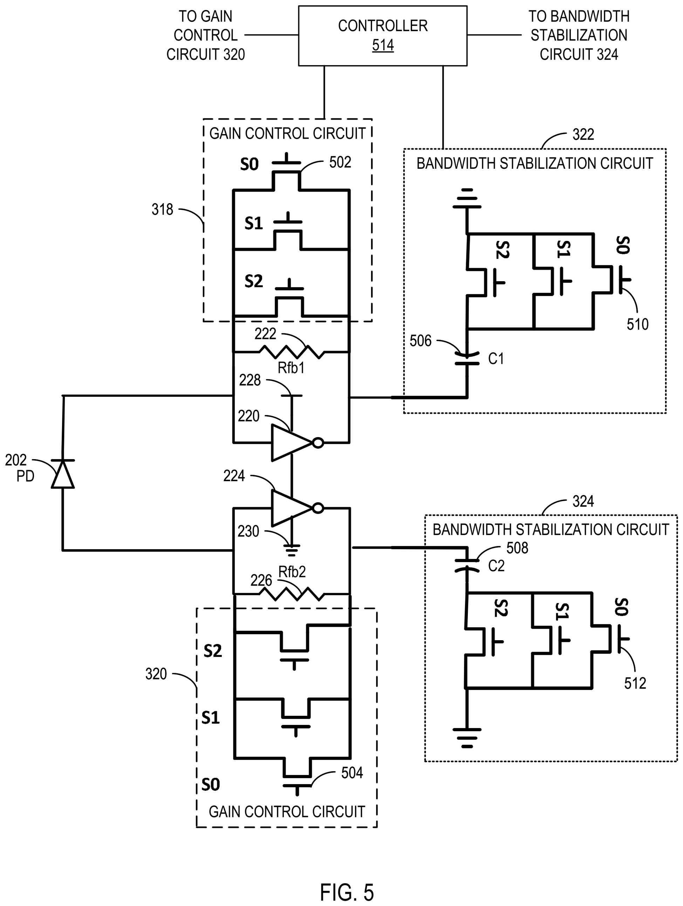

In the illustrated example, the optical receiver 300 includes at least one gain control circuit 318, 320 to accommodate the varying dynamic range required for communication signaling (e.g., PAM4 signaling). Example implementations of the gain control circuits 318, 320 are discussed below in connection with FIG. 5.

As shown, the at least one gain control circuit 318, 320 includes (i) a first gain control circuit 318 coupled to the first amplifier 220 and the first resistor 222 and (ii) a second gain control circuit 320 coupled to the second amplifier 224 and the second resistor 226. Alternatively, the optical receiver 300 may not include the first gain control circuit 318 and/or the second gain control circuit 320.

In some embodiments, the gain control circuits 318, 320 can be configured to increase a respective gain of the first amplifier 220 and the second amplifier 224. For example, the first gain control circuit 318 can be a programmable gain amplifier (PGA) stage coupled to the first amplifier 220 in a configuration to boost the output of the first amplifier 220 in accordance with operating conditions of the optical receiver 300. Beneficially, the gain control circuits 318, 320 can be respectively configured to provide more than 10dB gain adjustment range across different operating conditions of the optical receiver 300. Beneficially, the programmability of the gain control circuits 318, 320 can enable fine-tuning of portion(s) of the optical receiver 300 based on at least one of received signal strength (e.g., the generated photocurrents 212, 214) or modulation requirements (e.g., NRZ modulation requirements, PAM4 modulation requirements).

In the illustrated example, the optical receiver 300 includes at least one bandwidth stabilization circuit 322, 324 to enable gain peaking control for the first amplifier 220, the second amplifier 224, and/or, more generally, the TIA 204. Example implementations of the bandwidth stabilization circuits 322, 324 are discussed below in connection with FIG. 5.

As shown, the at least one bandwidth stabilization circuit 322, 324 includes (i) a first bandwidth stabilization circuit 322 coupled to the first amplifier 220 and the first resistor 222 and (ii) a second bandwidth stabilization circuit 324 coupled to the second amplifier 224 and the second resistor 226. Alternatively, the optical receiver 300 may not include the first bandwidth stabilization circuit 322 and/or the second bandwidth stabilization circuit 324.

Gain peaking refers to an amplifier's gain significantly increasing at a specific frequency range, creating a noticeable bump in the frequency response curve, and causing the output signal to be amplified more at higher frequencies than at lower frequencies, which is undesirable for communication signaling (e.g., PAM4 signaling). Beneficially, the at least one bandwidth stabilization circuit 322, 324 can be configured to reduce and/or mitigate gain peaking associated with operation of the first amplifier 220, the second amplifier 224, and/or, more generally, the TIA 204.

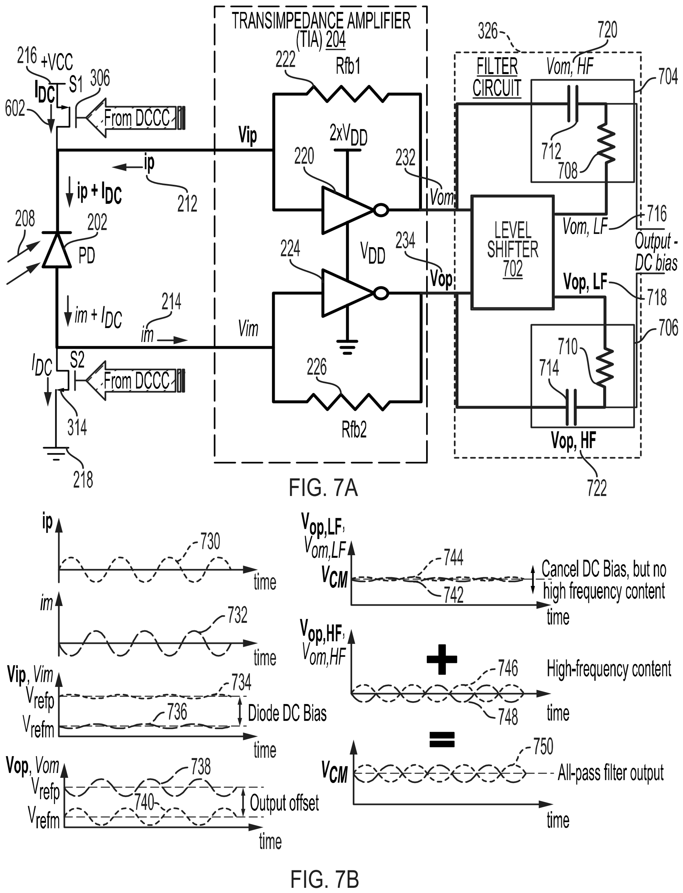

In the illustrated example, the optical receiver 300 includes a filter circuit 326 coupled to output(s) of the TIA 204 and input(s) of the output stage(s) 206. An example implementation of the filter circuit 326 is discussed below in connection with FIGS. 7A and 7B. Alternatively, the optical receiver 300 may not include the filter circuit 326.

The filter circuit 326 can be configured to remove (e.g., subtract) the DC bias difference between the first voltage 232 and the second voltage 234 while passing other contents of the differential signal to the output stage(s) 206. In some embodiments, the filter circuit 326 implements at least one filter. For example, the filter circuit 326 can be and/or implement at least one all pass filter. Beneficially, in such an example, implementing the filter circuit 326 as an all pass filter instead of another type of filter (e.g., a high-pass filter) can avoid the introduction of baseline wandering.

FIG. 4 shows an example implementation of the programmable diode stack 316 of FIG. 3. Other portion(s) of the optical receiver 300 of FIG. 3 is/are removed for clarity.

The programmable diode stack 316 includes at least one diode 402. The at least one diode 402 in this example includes a plurality of diodes. The diodes 402 are coupled together in series. For example, a first one of the diodes 402 (identified by D1) is coupled to a second one of the diodes 402 (e.g., D2 not shown), and the second one of the diodes 402 can be coupled to a third one of the diodes 402 (identified by DN).

The programmable diode stack 316 includes at least one switch 404. The at least one switch 404 in this example includes a plurality of switches. The switches 404 are coupled together in series. For example, a first one of the switches 404 (identified by S1) is coupled to a second one of the switches 404 (e.g., S2 not shown), and the second one of the switches 404 can be coupled to a third one of the switches 404 (identified by SN).

One(s) of the switches 404 can be transistors. Examples of transistors include a field-effect transistor (FET), a bipolar junction transistor (BJT) (e.g., an NPN BJT, a PNP BJT), and an insulated-gate bipolar transistor (IGBT). Examples of FETs include power FETs and MOSFETs (e.g., p-channel MOSFETs, n-channel MOSFETs, etc.). Any other type of transistor is contemplated.

The diodes 402 are coupled to the switches 404 in parallel. For example, S1 is coupled to D1 in parallel and SN is coupled to DN in parallel.

As shown, a quantity of the at least one diode 402 can be in a range of 1:N and a quantity of the at least one switch 404 can be in a range of 1:N such that the number of diodes 402 equals the number of switches 404. Alternatively, there may be a different number of diodes 402 than switches 404.

The programmable diode stack 316 is coupled to the first amplifier 220 and the second amplifier 224. As shown, S1 and D1 are coupled to a power supply terminal of the first amplifier 220, which in this example is a negative power supply terminal of the first amplifier 220. SN and DN are coupled to a power supply terminal of the second amplifier 224, which in this example is a positive power supply terminal of the second amplifier 224.

The programmable diode stack 316 includes a controller 406. Alternatively, the controller 406 may be separate from the programmable diode stack 316. Examples of the controller 406 include a CPU, a DSP, an FPGA, and a microcontroller. For example, the controller 406 can be a microcontroller.

As shown, the controller 406 is coupled to control terminals of the switches 404. For example, the controller 406 can be coupled to the switches 404 via an electrical bus. Examples of the electrical bus include an Inter-Integrated Circuit (I2C) bus and a Serial Peripheral Interface (SPI) bus. Alternatively, the electrical bus may be any other type of bus to effectuate control of the switches 404 by the controller 406.

In some embodiments, the photodetector 202 needs more bias (e.g., reverse bias) for operation than the voltage generated across the TIA 204. For example, the controller 406 can detect that the photodetector 202 is receiving too much power from the optical signal 208 and determine to reduce the reverse bias of the photodetector 202. In another example, the controller 406 can detect that the photodetector 202 is receiving too little power from the optical signal 208 due to the optical signal 208 being weak and determine to increase the reverse bias of the photodetector 202.

The controller 406 can detect operating conditions of the photodetector 202 based on a received signal strength indicator (RSSI) associated with the photocurrents 212, 214. For example, the controller 406 can be coupled to outputs of the third amplifier 304 and the fourth amplifier 312 to receive measurements indicative of the RSSI of the photocurrents 212, 214 and control the programmable diode stack 316 accordingly.

To increase the voltage for reverse biasing the photodetector 202, the controller 406 can be configured (e.g., instructed, programmed) to open or close one(s) of the switches 404. In some embodiments, the controller 406 can control the switches 404 independently of each other. For example, the controller 406 can close S1 and open SN.

In example operation, the controller 406 can control the reverse bias of the photodetector 202 by controlling the switches 404. For example, the controller 406 can increase the reverse bias of the photodetector 202 in increments of approximately 0.7 volts (V) for each one of the switches 404 the controller 406 opens. In such an example, the controller 406 can increase the reverse bias of the photodetector 202 by approximately 0.7 V by opening S1, 1.4 V by opening S1 and S2 (not shown), and so on.

Beneficially, in some embodiments, the programmable diode stack 316 can be configured to adjust the reverse bias of the photodetector 202 dynamically to improve the bandwidth and/or sensitivity of the photodetector 202. Additionally, the programmable diode stack 316 can be configured to maintain a relatively low AC resistance, further boosting signal integrity without compromising bandwidth.

FIG. 5 shows example implementations of the gain control circuits 318, 320 and the bandwidth stabilization circuits 322, 324 of FIG. 3. Other portion(s) of the optical receiver 300 of FIG. 3 is/are removed for clarity.

The gain control circuits 318, 320 in this example are implemented by respective pluralities of switches 502, 504, which include a first plurality of switches 502 and a second plurality of switches 504. The first plurality of switches 502 is coupled to the first amplifier 220 and the first resistor 222 in parallel. The second plurality of switches 504 is coupled to the second amplifier 224 and the second resistor 226 in parallel. One(s) of the switches 502, 504 can be transistors.

The bandwidth stabilization circuits 322, 324 in this example are implemented at least in part by a respective capacitor 506, 508. The capacitors 506, 508 include a first capacitor 506 (identified by C1) and a second capacitor 508 (identified by C2). The first capacitor 506 is coupled to the first amplifier 220 and the first resistor 222 in parallel. The second capacitor 508 is coupled to the second amplifier 224 and the second resistor 226 in parallel.

The bandwidth stabilization circuits 322, 324 in this example are implemented at least in part by respective pluralities of switches 510, 512, which include a third plurality of switches 510 and a fourth plurality of switches 512. The first plurality of switches 510 is coupled to the first amplifier 220 and the first resistor 222 through the first capacitor 506. The second plurality of switches 512 is coupled to the second amplifier 224 and the second resistor 226 through the second capacitor 508.One(s) of the switches 510, 512 can be transistors.

In the illustrated example, a controller 514 is coupled to the gain control circuits 318, 320 and the bandwidth stabilization circuits 322, 324. For example, the controller 514 can be coupled to respective control terminals of the switches 502, 504, 510, 512 via an electrical bus, such as an I2C bus or a SPI bus.

The controller 514 can be implemented by a CPU, a DSP, an FPGA, or a microcontroller. In some embodiments, the controller 514 of FIG. 5 and the controller 406 are the same controller while in other embodiments they are different.

In some embodiments, the controller 514 controls one(s) of the gain control circuits 318, 320. For example, the controller 514 can be configured (e.g., programmed) to increase a respective gain of the first amplifier 220, the second amplifier 224, and/or, more generally, the TIA 204. In such an example, the controller 514 can increase the gain for each one of the switches 502, 504 of the gain control circuits 318, 320 the controller 514 closes. By way of example, the controller 514 can increase the gain of the first amplifier 220 and/or, more generally, the TIA 204, by closing switch S0 of the first plurality of switches 502 in the first gain control circuit 318.

In some embodiments, the controller 514 controls one(s) of the bandwidth stabilization circuits 322, 324 to reduce gain peaking that may result from the gain control circuits 318, 320 increasing the gain of the amplifiers 220, 224. For example, the bandwidth of the amplifiers 220, 224 increases as more of the switches 502, 504 of the gain control circuits 318, 320 are enabled. However, such an increase in bandwidth can increase the noise in the optical receiver 300. To reduce the increased noise that may result, the controller 514 can control the bandwidth stabilization circuits 322, 324 to reduce to limit the increase in the bandwidth.

In some embodiments, the controller 514 can be configured (e.g., programmed) to limit and/or reduce gain peaking of the first amplifier 220, the second amplifier 224, and/or, more generally, the TIA 204. For example, the controller 514 can be configured to close S0 of the first gain control circuit 318 to increase a gain of the first amplifier 220. In such an example, the bandwidth of the first amplifier 220 increases with the increased gain. The controller 514 can be configured to close S0 of the first bandwidth stabilization circuit 322 to reduce and/or limit the increase in the bandwidth resulting from the increased gain of the first amplifier 220. Additionally and/or alternatively, more switches than S0 may be closed to reduce and/or limit the bandwidth, such as closing S1 and/or S2 in addition to S0.

In such an example, the controller 514 can decrease the bandwidth for each one of the switches 510, 512 of the bandwidth stabilization circuits 322, 324 the controller 514 closes. For example, the controller 514 can decrease the bandwidth of the first amplifier 220 and/or, more generally, the TIA 204, by closing switch S0 of the third plurality of switches 510 in the first bandwidth stabilization circuit 322.

Beneficially, the gain control circuits 318, 320 can be incorporated, integrated, and/or included in the optical receiver 300 to accommodate the varying dynamic range required for different signaling schemes in high-bandwidth communication signaling, such as PAM4 signaling. The gain control circuits 318, 320 can be configured to provide at least a 10dB gain adjustment range with peaking control, via the bandwidth stabilization circuits 322, 324, across different operating conditions of the optical receiver 300 to allow for fine-tuning based on the received signal strength and/or modulation requirements of the utilized signaling scheme.

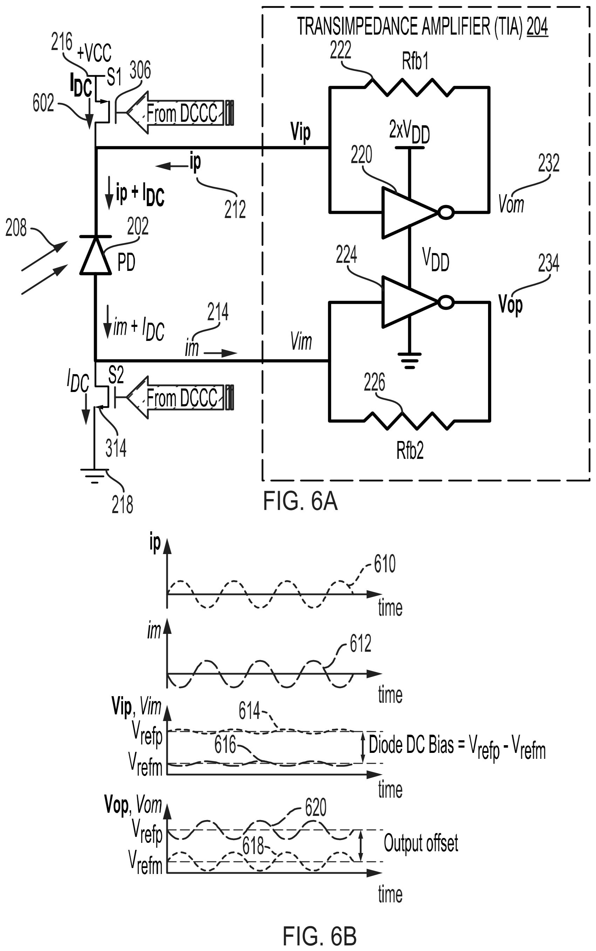

FIG. 6A shows example operation of a portion of the optical receiver 300 of FIG. 3. The portion shown includes the photodetector 202, the TIA 204, the first amplifier 220, the first resistor 222, the second amplifier 224, and the second resistor 226, the first switch 306, and the second switch 314 of FIGS. 2 and/or 3.

As shown, the photodetector 202 converts the optical signal 208 of FIG. 2 into the photocurrents 212, 214. The first DCCC loop discussed above in connection with FIG. 3 controls the first switch 306 to conduct such that a DC current 602 (identified by I_{DC}) flows through the first switch 306. The second DCCC loop discussed above in connection with FIG. 3 controls the second switch 314 to conduct such that the DC current 602 flows through the second switch 314. As shown, the TIA 204 generates the first voltage 232 and the second voltage 234 based on input voltages identified by Vip and Vim.

FIG. 6B shows waveforms 610, 612, 614, 616, 618, 620 representing example operation of the portion of the optical receiver 300 shown in FIG. 6A. The waveforms 610, 612, 614, 616, 618, 620 include a first waveform 610, a second waveform 612, a third waveform 614, a fourth waveform 616, a fifth waveform 618, and a sixth waveform 620.

The first waveform 610 is a current measurement of the first photocurrent 212 with respect to time. The second waveform 612 is a current measurement of the second photocurrent 214 with respect to time.

The third waveform 614 is a voltage measurement of the input voltage Vip with respect to time. The fourth waveform 616 is a voltage measurement of the input voltage Vim with respect to time. As shown, a voltage difference between the third waveform 614 and the fourth waveform 616 is the diode DC bias, which is a difference between the first reference voltage 308 and the second reference voltage 315 of FIG. 3.

The fifth waveform 618 is a voltage measurement of the first voltage 232 identified by Vom with respect to time. The sixth waveform 620 is a voltage measurement of the second voltage 234 identified by Vop with respect to time. As shown, a voltage difference between the first voltage 232 and the second voltage 234 is an unwanted output offset due to the diode DC bias. Beneficially, this unwanted output offset can be removed by the filter circuit 326 of FIG. 3 as discussed further below in connection with FIGS. 7A and 7B.

FIG. 7A shows example operation of at least another portion of the optical receiver 300 of FIG. 3. The portion shown includes the photodetector 202, the TIA 204, the first amplifier 220, the first resistor 222, the second amplifier 224, and the second resistor 226, the first switch 306, and the second switch 314 of FIGS. 2 and/or 3.

The portion shown also includes an example implementation of the filter circuit 326 of FIG. 3. The filter circuit 326 shown includes a level shifter 702 and resistor-capacitor (RC) networks 704, 706, which include a first RC network 704 and a second RC network 706. Each of the RC networks 704, 706 include a respective resistor 708, 710 and capacitor 712, 714.

As shown, the level shifter 702 is coupled to respective outputs of the amplifiers 220, 224 and/or, more generally, the TIA 204. The level shifter 702 includes a first level shifter input coupled to an output (e.g., an amplifier output) of the first amplifier 220 to receive the first voltage 232. The level shifter 702 includes a second level shifter input coupled to an output (e.g., an amplifier output) of the second amplifier 220 to receive the second voltage 234.

As shown, the first RC network 704 is coupled to the first amplifier 220 and the level shifter 702. A first output of the level shifter (e.g., a level shifter output) is coupled to a first terminal of the first resistor 708, a second terminal of the first resistor 708 is coupled to a first terminal of the first capacitor 712, and a second terminal of the first capacitor 712 is coupled to the output of the first amplifier 220.

As shown, the second RC network 706 is coupled to the second amplifier 224 and the level shifter 702. A second output of the level shifter (e.g., a level shifter output) is coupled to a first terminal of the second resistor 710, a second terminal of the second resistor 710 is coupled to a first terminal of the second capacitor 714, and a second terminal of the second capacitor 714 is coupled to the output of the second amplifier 224.

The filter circuit 326 shown implements an all-pass filter. For example, the level shifter 702 can be configured to pass the low-frequency content of the first voltage 232 and the second voltage 234 and the RC networks 704, 706 can be configured to pass the high-frequency content of the first voltage 232 and the second voltage 234. In such an example, the low-frequency and high-frequency content of the first voltage 232 and the second voltage 234 can be combined for output from the filter circuit 326 with the signal bandwidth intact and with the DC bias removed.

In some embodiments, the level shifter 702 can perform DC level shifting. For example, the level shifter 702 can be configured for bias removal (e.g., DC bias removal), such as removal of the unwanted output offset shown in FIG. 6B.

Examples of the level shifter 702 include a switched capacitor circuit, a differential pair, and an op-amp based buffer. Such examples of the level shifter 702 are effective in removing DC bias, but they are bandwidth limited.

In example operation, the level shifter 702 receives the first voltage 232 and the second voltage 234. The level shifter 702 can translate the second voltage 234 to the voltage level of the first voltage 232 to remove and/or cancel the DC bias. The level shifter 702 can output the low frequency content of the first voltage 232 as a first low frequency voltage 716 (identified by Vom,LF) and output the low frequency content of the second voltage 234 as a second low frequency voltage 718 (identified by Vop,LF). However, the level shifter 702 may remove the high frequency content of the first voltage 232 and the second voltage 234.

To compensate for any potential signal loss from the level shifter 702, the filter circuit 326 includes additional high-frequency paths. As shown, the high-frequency paths are implemented using the RC networks 704, 706. For example, the high-frequency path for the output of the first amplifier 220 is the first RC network 704 and the high-frequency path for the output of the second amplifier 224 is the second RC network 706.

In example operation, the first voltage 232 is provided to the first capacitor 712. The first capacitor 712, the first resistor 708, and/or, more generally, the first RC network 704, implements a high-pass filter that allows the high-frequency content of the first voltage 232 to pass through the first RC network 704 as a first high-frequency voltage 720 (identified by Vom,HF). The high-frequency content and the low-frequency content of the first voltage 232 are combined by combining the first low frequency voltage 716 and the first high-frequency voltage 720 at the output of the filter circuit 326.

In example operation, the second voltage 234 is provided to the second capacitor 714. The second capacitor 714, the second resistor 710, and/or, more generally, the second RC network 706, implements a high-pass filter that allows the high-frequency content of the second voltage 234 to pass through the second RC network 706 as a second high-frequency voltage 722 (identified by Vop,HF). The high-frequency content and the low-frequency content of the second voltage 234 are combined by combining the second low frequency voltage 718 and the second high-frequency voltage 722 at the output of the filter circuit 326.

FIG. 7B shows waveforms 730, 732, 734, 736, 738, 740, 742, 744, 746, 748, 750 representing example operation of the portion of the optical receiver 300 shown in FIG. 7A. The waveforms 730, 732, 734, 736, 738, 740, 742, 744, 746, 748, 750 include a first waveform 730, a second waveform 732, a third waveform 734, a fourth waveform 736, a fifth waveform 738, a sixth waveform 740, a seventh waveform 742, an eighth waveform 744, a ninth waveform 746, a tenth waveform 748, and an eleventh waveform 750.

The first waveform 730 is a current measurement of the first photocurrent 212 with respect to time. The second waveform 732 is a current measurement of the second photocurrent 214 with respect to time.

The third waveform 734 is a voltage measurement of the input voltage Vip with respect to time. The fourth waveform 736 is a voltage measurement of the input voltage Vim with respect to time. As shown, a voltage difference between the third waveform 734 and the fourth waveform 736 is the diode DC bias, which is a difference between the first reference voltage 308 and the second reference voltage 315 of FIG. 3.

The fifth waveform 738 is a voltage measurement of the first voltage 232 identified by Vom with respect to time. The sixth waveform 740 is a voltage measurement of the second voltage 234 identified by Vop with respect to time. As shown, a voltage difference between the first voltage 232 and the second voltage 234 is an unwanted output offset due to the diode DC bias. Beneficially, this unwanted output offset can be removed by the example implementation of the filter circuit 326 shown in FIG. 7A.

The seventh waveform 742 and the eighth waveform 744 represent the outputs from the level shifter 702 of FIG. 7A, which are the low-frequency content of the first voltage 232 and the second voltage 234. The seventh waveform 742 is a voltage measurement of the first low frequency voltage 716 of FIG. 7A. The eighth waveform 744 is a voltage measurement of the second low frequency voltage 718 of FIG. 7A.

The ninth waveform 746 and the tenth waveform 748 represent the outputs of the RC networks 704, 706 of FIG. 7A, which are the high-frequency content of the first voltage 232 and the second voltage 234. The ninth waveform 746 is a voltage measurement of the first high frequency voltage 720 of FIG. 7A. The tenth waveform 748 is a voltage measurement of the second high frequency voltage 722 of FIG. 7A.

The eleventh waveform 750 represents the combination of the low-frequency content output from the level shifter 702 and the high-frequency content output from the RC networks 704, 706. The eleventh waveform 750 is the common mode voltage (identified by V_{CM}), which is the output from the all-pass filter implemented by the filter circuit 326. Beneficially, the common mode voltage is substantially the same as the output from the TIA 204 (e.g., the voltage difference between the first voltage 232 and the second voltage 234) with the DC bias removed.

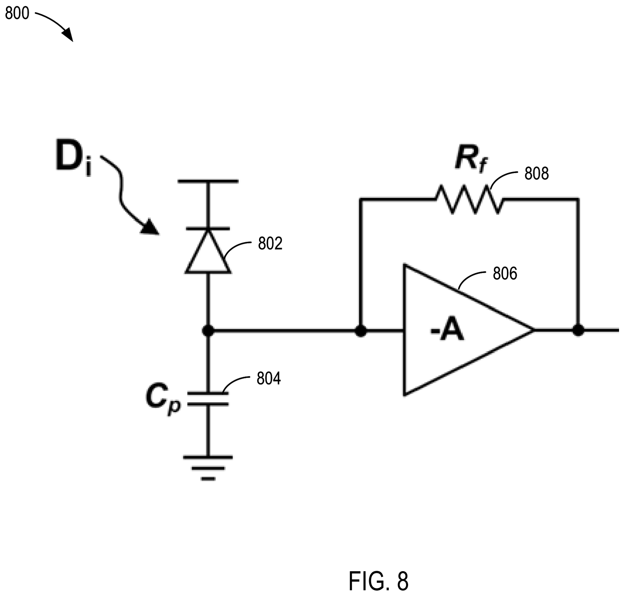

FIG. 8 shows an example implementation of a TIA 800. The TIA 800 includes a photodiode 802, a capacitor 804, an inverting amplifier 806, and a feedback resistor 808. The TIA 800 shown in FIG. 8 is a single-ended shunt-feedback TIA (SE-SF-TIA). In a SE-SF-TIA implementation, as shown, only the anode side of the photodiode 802 is used as the cathode side current is dumped to AC ground. The inventors have recognized that the SE-SF-TIA 800 shown in FIG. 8 suffers from debilitating tradeoffs between its noise and bandwidth because, since it only measures the signal on one line (e.g., the anode side), it is susceptible to noise (e.g., external noise sources) and common-mode interference.

Beneficially, the example TIA implementations described herein, such as the TIA 204 of FIGS. 2, 3, 6A, and/or 7A, utilize a differential TIA architecture that leverages a stacked shunt-feedback design that effectively doubles the signal current. The differential TIA architecture doubles the signal current by utilizing both branches of the photodetector (e.g., the photodiode 802) resulting in a theoretical 3dB improvement in SNR without a corresponding increase in noise floor.

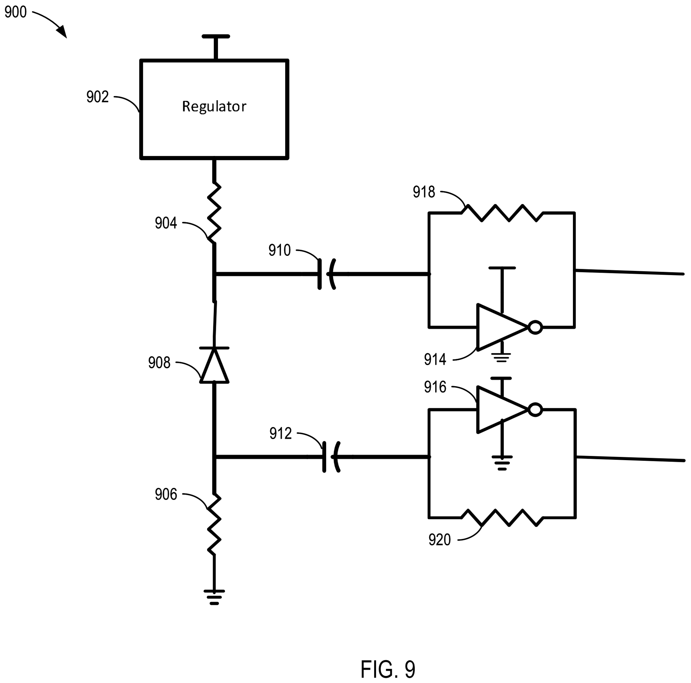

FIG. 9 shows another example implementation of a TIA 900. The TIA 900 includes a regulator 902, resistors 904, 906, a photodiode 908, capacitors 910, 912, inverting amplifiers 914, 916, and feedback resistors 918, 920. The TIA 900 shown in FIG. 9 is a differential TIA that uses the photocurrent flowing out of both terminals of the photodiode 908. Since the photodetector current also flows in the complementary branch, the signal increases by 6dB at the cost of a 3dB increase in noise, resulting in a theoretical 3dB increase in SNR. However, in contrast to the SE-SF-TIA 800 shown in FIG. 8, the photodiode 908 in a differential TIA implementation as shown in FIG. 9 needs reverse bias to have high bandwidth.

The inventors have recognized that since the resistance (R) of the resistors 904, 906 is relatively small, the cutoff frequency (determined by 1/RC) becomes relatively large and therefore reduces the bandwidth of the TIA 900. For example, the inventors have recognized that since high-speed communication signals (e.g., PAM4 signals) have a wide frequency range (e.g., a frequency range from DC up to tens of gigahertz (GHz) such as 10, 20, 30 GHz), the use of the capacitors 910, 912 as high-pass filters blocks at least part of the received signal, which is undesirable. Further, the inventors have recognized that the capacitors 910, 912 can increase baseline wandering because they block DC components of the photocurrent, which is particularly problematic in wireline applications.

Beneficially, in some embodiments, the programmable diode stack 316 of FIGS. 3 and/or 4 overcomes the technical challenge of reduced bandwidth in the TIA 900. For example, some differential TIAs disclosed herein, such as the TIA 204 of FIGS. 2, 3, 6A, and/or 7A, can include the programmable diode stack 316 that adjusts the photodetector's 202 reverse bias dynamically to optimize and/or otherwise improve bandwidth.

Beneficially, in some embodiments, the DCCC loops of FIG. 3 overcomes the technical challenge of introducing baseline wandering in the TIA 900. For example, the DCCC loops of FIG. 3 can avoid baseline wandering by maintaining a low high-pass corner frequency.

While an example implementation of a TIA is depicted in FIGS. 2, 3, 4, 5, 6A, and/or 7A, other implementations are contemplated. For example, one or more blocks, components, functions, etc., of the TIA 204, or portion(s) thereof, depicted in FIGS. 2, 3, 4, 5, 6A, and/or 7A may be combined or divided in any other way. The TIA 204, or portion(s) thereof, depicted in FIGS. 2, 3, 4, 5, 6A, and/or 7A may be implemented by hardware alone, or by a combination of hardware, software, and/or firmware. For example, the TIA 204, or portion(s) thereof, depicted in FIGS. 2, 3, 4, 5, 6A, and/or 7A may be implemented by one or more analog circuits (e.g., capacitors, comparators, diodes, inductors, operational amplifiers, resistors, transistors, etc.), one or more digital circuits (e.g., logic gates, etc.), one or more hardware-implemented state machines, one or more programmable processors, one or more ASICs, etc., and/or any combination(s) thereof. The TIA 204, or portion(s) thereof, depicted in FIGS. 2, 3, 4, 5, 6A, and/or 7A can be implemented by one or more integrated circuits (ICs) on the same die or one or more ICs on two or more different dies, such as one or more ICs on a first die and one or more ICs on a second die.

In some embodiments, the TIA 204, or portion(s) thereof, depicted in FIGS. 2, 3, 4, 5, 6A, and/or 7A may be implemented by a system on a chip or system-on-chip (SoC). An SoC is an integrated circuit design that combines elements of an electronic device onto a single chip instead of using separate components. For example, an SoC may include and/or incorporate within itself one or more programmable processors, input and output (I/O) ports, memory, analog input blocks, analog output blocks, etc., and/or any combination(s) thereof. For example, the TIA 204, or portion(s) thereof, depicted in FIGS. 2, 3, 4, 5, 6A, and/or 7A may be implemented by a single platform and integrates an entire electronic device (or portion(s) thereof), such as a receiver device, onto the platform.

Various aspects of the embodiments described above may be used alone, in combination, or in a variety of arrangements not specifically discussed in the embodiments described in the foregoing and is therefore not limited in its application to the details and arrangement of components set forth in the foregoing description or illustrated in the drawings. For example, aspects described in one embodiment may be combined in any manner with aspects described in other embodiments.

The phrase "and/or," as used herein in the specification and in the claims, should be understood to mean "either or both," of the elements so conjoined, e.g., elements that are conjunctively present in some cases and disjunctively present in other cases. Multiple elements listed with "and/or" should be construed in the same fashion, e.g., "one or more" of the elements so conjoined. Other elements may optionally be present other than the elements specifically identified by the "and/or" clause, whether related or unrelated to those elements specifically identified. Thus, as a non-limiting example, a reference to "A and/or B," when used in conjunction with open-ended language such as "comprising" can refer, in one embodiment, to A only (optionally including elements other than B); in another embodiment, to B only (optionally including elements other than A); in yet another embodiment, to both A and B (optionally including other elements); etc.

The indefinite articles "a" and "an," as used herein in the specification and in the claims, unless clearly indicated to the contrary, should be understood to mean "at least one."

As used herein in the specification and in the claims, the phrase, "at least one," in reference to a list of one or more elements, should be understood to mean at least one element selected from any one or more of the elements in the list of elements, but not necessarily including at least one of each and every element specifically listed within the list of elements and not excluding any combinations of elements in the list of elements. This definition also allows that elements may optionally be present other than the elements specifically identified within the list of elements to which the phrase "at least one" refers, whether related or unrelated to those elements specifically identified. Thus, as a non-limiting example, "at least one of A and B" (or, equivalently, "at least one of A or B," or, equivalently, "at least one of A and/or B") can refer, in one embodiment, to at least one, optionally including more than one, A, with no B present (and optionally including elements other than B); in another embodiment, to at least one, optionally including more than one, B, with no A present (and optionally including elements other than A); in yet another embodiment, to at least one, optionally including more than one, A, ,and at least one, optionally including more than one, B (and optionally including other elements); etc.

Use of ordinal terms such as "first," "second," "third," etc., in the claims to modify a claim element does not by itself connote any priority, precedence, or order of one claim element over another or the temporal order in which acts of a method are performed, but are used merely as labels to distinguish one claim element having a certain name from another element having a same name (but for use of the ordinal term) to distinguish the claim elements.

Also, the phraseology and terminology used herein is for the purpose of description and should not be regarded as limiting. The use of "including," "comprising," "having," "containing," "involving," and variations thereof herein, is meant to encompass the items listed thereafter and equivalents thereof as well as additional items.

All definitions, as defined and used herein, should be understood to control over dictionary definitions, definitions in documents incorporated by reference, and/or ordinary meanings of the defined terms.

Having thus described several aspects of at least one embodiment, it is to be appreciated that various alterations, modifications, and improvements will readily occur to those skilled in the art. Such alterations, modifications, and improvements are intended to be part of this disclosure and are intended to be within the spirit and scope of the principles described herein. Accordingly, the foregoing description and drawings are by way of example only.

Various aspects are described in this disclosure, which include, but are not limited to, the following aspects:
1. A transimpedance amplifier comprising: a first amplifier comprising a first terminal; and a second amplifier comprising a second terminal, the second terminal coupled to the first terminal, wherein the first amplifier and the second amplifier are configured to reverse bias a photodetector.
2. The transimpedance amplifier of aspect 1, wherein at least one of the first amplifier or the second amplifier is an inverting amplifier.
3. The transimpedance amplifier of aspect 1, wherein: the first terminal is a negative power supply terminal of the first amplifier, and the second terminal is a positive power supply terminal of the second amplifier.
4. The transimpedance amplifier of aspect 1, wherein an apparatus comprises the transimpedance amplifier and the photodetector.
5. The transimpedance amplifier of aspect 4, wherein the photodetector is a photodiode.
6. The transimpedance amplifier of aspect 4, wherein the photodetector comprises a first photodetector terminal and a second photodetector terminal, the first photodetector terminal is coupled to an input of the first amplifier, and the second terminal is coupled to an input of the second amplifier.
7. The transimpedance amplifier of aspect 1, wherein the first and second amplifiers are configured to convert at least one current output from the photodetector into a differential voltage.
8. The transimpedance amplifier of aspect 1, further comprising: a first resistor coupled to an input and an output of the first amplifier; and a second resistor coupled to an input and an output of the second amplifier.
9. A circuit comprising: a transimpedance amplifier comprising: a first amplifier comprising a first terminal; and a second amplifier comprising a second terminal, the second terminal coupled to the first terminal, wherein the first amplifier and the second amplifier are configured to reverse bias a photodetector; and a filter circuit coupled to the transimpedance amplifier and configured to reduce the bias from an output of the transimpedance amplifier.
10. The circuit of aspect 9, further comprising the photodetector.
11. The circuit of aspect 9, wherein the transimpedance amplifier further comprises: a first resistor coupled to an input and an output of the first amplifier; and a second resistor coupled to an input and an output of the second amplifier.
12. The circuit of aspect 9, wherein the filter circuit comprises an all-pass filter.
13. The circuit of aspect 12, wherein the first amplifier comprises a first amplifier output, the second amplifier comprises a second amplifier output, and the all-pass filter comprises: a level shifter comprising a first level shifter output, a second level shifter output, a first level shifter input coupled to the first amplifier output, and a second level shifter input coupled to the second amplifier output; a first resistor-capacitor network coupled to the first level shifter output and the first amplifier output; and a second resistor-capacitor network coupled to the second level shifter output and the second amplifier output.
14. The circuit of aspect 9, wherein the first amplifier comprises a first amplifier input and a first amplifier output, and further comprising: a first switch comprising a first current terminal and a first control terminal, the first current terminal coupled to the first amplifier input; a first filter comprising a first filter input and a first filter output, the first filter input coupled to the first amplifier output; and a third amplifier coupled to the first filter output and the first control terminal.
15. The circuit of aspect 14, wherein the second amplifier comprises a second amplifier input and a second amplifier output, and further comprising: a second switch comprising a second current terminal and a second control terminal, the second current terminal coupled to the second amplifier input and the first current terminal through the photodetector; a second filter comprising a second filter input and a second filter output, the second filter input coupled to the second amplifier output; and a fourth amplifier coupled to the second filter output and the second control terminal.
16. The circuit of aspect 9, further comprising: at least one diode coupled to the first amplifier and the second amplifier through at least one switch.
17. The circuit of aspect 16, wherein the at least one diode comprises at least (i) a first diode coupled to the first terminal of the first amplifier and (ii) a second diode coupled to the second terminal of the second amplifier, the at least one switch comprises at least a first switch and a second switch, and wherein: the first switch is coupled to an anode and a cathode of the first diode, and the second switch is coupled to an anode and a cathode of the second diode.
18. The circuit of aspect 9, further comprising: a first gain control circuit comprising a first plurality of switches, the first gain control circuit coupled to the first amplifier through the first plurality of switches; and a second gain control circuit comprising a second plurality of switches, the second gain control circuit coupled to the second amplifier.
19. The circuit of aspect 18, further comprising a controller configured to at least one of control the first plurality of switches to control a first gain of the first amplifier or control the second plurality of switches to control a second gain of the second amplifier.
20. The circuit of aspect 9, further comprising: a first bandwidth stabilization circuit comprising a first capacitor and a first plurality of switches, the first bandwidth stabilization circuit coupled to the first amplifier through the first capacitor; and a second bandwidth stabilization circuit comprising a second capacitor and a second plurality of switches, the second bandwidth stabilization circuit coupled to the second amplifier through the second capacitor.
21. The circuit of aspect 20, further comprising a controller configured to at least one of control the first plurality of switches to control a first bandwidth of the first amplifier or control the second plurality of switches to control a second bandwidth of the second amplifier.
22. An optical receiver comprising: a transimpedance amplifier circuit configured to receive a current converted from an optical signal by a photodetector, the transimpedance amplifier circuit comprising a first amplifier and a second amplifier in a stacked arrangement configured to reverse bias the photodetector; a first direct current control loop configured to control current through a first feedback network of the first amplifier; and a second direct current control loop configured to control current through a second feedback network of the first amplifier.
23. The optical receiver of aspect 22, further comprising a filter circuit coupled to the transimpedance amplifier circuit and configured to reduce the bias from an output of the optical receiver.
24. The optical receiver of aspect 22, further comprising at least two diodes and at least two respective switches coupled to the transimpedance amplifier circuit in a stacked arrangement configured to control the reverse bias of the photodetector.
25. The optical receiver of aspect 22, further comprising: a first gain control circuit coupled to the first amplifier and configured to control a first gain of the first amplifier; and a second gain control circuit coupled to the second amplifier and configured to control a second gain of the second amplifier.
26. The optical receiver of aspect 22, further comprising: a first bandwidth stabilization circuit coupled to the first amplifier and configured to control a first bandwidth of the first amplifier; and a second bandwidth stabilization circuit coupled to the second amplifier and configured to control a second bandwidth of the second amplifier.
27. The optical receiver of aspect 22, further comprising a controller configured to control the reverse bias of the photodetector.
28. The optical receiver of aspect 22, further comprising a controller configured to control at least one of a gain or bandwidth of the transimpedance amplifier circuit.
29. The optical receiver of aspect 22, further comprising the photodetector.

## Claims

1. A transimpedance amplifier comprising:
a first amplifier comprising a first terminal; and
a second amplifier comprising a second terminal, the second terminal coupled to the first terminal, wherein the first amplifier and the second amplifier are configured to reverse bias a photodetector.

2. The transimpedance amplifier of claim 1, wherein at least one of the first amplifier or the second amplifier is an inverting amplifier; and/or
wherein the first and second amplifiers are configured to convert at least one current output from the photodetector into a differential voltage; and/or
wherein the first terminal is a negative power supply terminal of the first amplifier, and the second terminal is a positive power supply terminal of the second amplifier; and/or
wherein the photodetector comprises a first photodetector terminal and a second photodetector terminal, an input of the first amplifier is configured to be coupled to the first photodetector terminal, and an input of the second amplifier is configured to be coupled to the second photodetector terminal.

3. The transimpedance amplifier of claim 1 or 2, further comprising: a first resistor coupled to an input and an output of the first amplifier; and a second resistor coupled to an input and an output of the second amplifier.

4. A circuit comprising:
the transimpedance amplifier of one of claims 1 to 3; and
a filter circuit coupled to the transimpedance amplifier and configured to reduce the bias from an output of the transimpedance amplifier.

5. The circuit of claim 4, further comprising the photodetector.

6. The circuit of claim 4 or 5, wherein the first amplifier comprises a first amplifier output, the second amplifier comprises a second amplifier output, the filter circuit comprises an all-pass filter comprising:
a level shifter comprising a first level shifter output, a second level shifter output, a first level shifter input coupled to the first amplifier output, and a second level shifter input coupled to the second amplifier output;
a first resistor-capacitor network coupled to the first level shifter output and the first amplifier output; and
a second resistor-capacitor network coupled to the second level shifter output and the second amplifier output.

7. The circuit of one of claims 4 to 6, wherein the first amplifier comprises a first amplifier input and a first amplifier output, and further comprising:
a first switch comprising a first current terminal and a first control terminal, the first current terminal coupled to the first amplifier input;
a first filter comprising a first filter input and a first filter output, the first filter input coupled to the first amplifier output; and
a third amplifier coupled to the first filter output and the first control terminal.

8. The circuit of one of claims 4 to 7, wherein the second amplifier comprises a second amplifier input and a second amplifier output, and further comprising:
a second switch comprising a second current terminal and a second control terminal, the second current terminal coupled to the second amplifier input and the first current terminal through the photodetector;
a second filter comprising a second filter input and a second filter output, the second filter input coupled to the second amplifier output; and
a fourth amplifier coupled to the second filter output and the second control terminal.

9. The circuit of one of claims 4 to 8, further comprising at least one diode coupled to the first amplifier and the second amplifier through at least one switch, and wherein:
the at least one diode comprises at least (i) a first diode coupled to the first terminal of the first amplifier and (ii) a second diode coupled to the second terminal of the second amplifier, the at least one switch comprises at least a first switch and a second switch,
the first switch is coupled to an anode and a cathode of the first diode, and
the second switch is coupled to an anode and a cathode of the second diode.

10. The circuit of one of claims 4 to 9, further comprising:
a first gain control circuit comprising a first plurality of switches, the first gain control circuit coupled to the first amplifier through the first plurality of switches; and
a second gain control circuit comprising a second plurality of switches, the second gain control circuit coupled to the second amplifier.

11. The circuit of one of claims 4 to 10, further comprising:
a first bandwidth stabilization circuit comprising a first capacitor and a first plurality of switches, the first bandwidth stabilization circuit coupled to the first amplifier through the first capacitor; and
a second bandwidth stabilization circuit comprising a second capacitor and a second plurality of switches, the second bandwidth stabilization circuit coupled to the second amplifier through the second capacitor.

12. An optical receiver comprising:
a transimpedance amplifier circuit configured to receive a current converted from an optical signal by a photodetector, the transimpedance amplifier circuit comprising a first amplifier and a second amplifier in a stacked arrangement configured to reverse bias the photodetector and/or the circuit of one of claims 4 to 11;
a first direct current control loop configured to control current through a first feedback network of the first amplifier; and
a second direct current control loop configured to control current through a second feedback network of the first amplifier.

13. The optical receiver of claim 12, further comprising at least one of:
a filter circuit coupled to the transimpedance amplifier circuit and configured to reduce the bias from an output of the optical receiver; and
at least two diodes and at least two respective switches coupled to the transimpedance amplifier circuit in a stacked arrangement configured to control the reverse bias of the photodetector; and
a controller configured to control at least one of the reverse bias of the photodetector, a gain of the transimpedance amplifier circuit, or a bandwidth of the transimpedance amplifier circuit.

14. The optical receiver of claim 12 or 13, further comprising:
a first gain control circuit coupled to the first amplifier and configured to control a first gain of the first amplifier; and
a second gain control circuit coupled to the second amplifier and configured to control a second gain of the second amplifier.

15. The optical receiver of one of claims 12 to 14, further comprising:
a first bandwidth stabilization circuit coupled to the first amplifier and configured to control a first bandwidth of the first amplifier; and
a second bandwidth stabilization circuit coupled to the second amplifier and configured to control a second bandwidth of the second amplifier.
